# EUROPEAN PATENT APPLICATION

(11) **EP 4 339 994 A1**
(43) Date of publication of application: **20.03.2024**
(21) Application number: 23196075.8
(22) Date of filing: 07.09.2023
(51) Int. Cl.: H01J 37/22, H01J 37/28

(54) **TRANSMISSION ELECTRON MICROSCOPE**

(30) Priority: 16.09.2022 JP 2022147740
(71) Applicant: Jeol Ltd., Akishima-shi, Tokyo 196-8558 (JP)
(72) Inventor: NOGUCHI, Kanako, Tokyo, 196-8558 (JP)
(74) Representative: Boult Wade Tennant LLP

(57) **Abstract**

A laser beam illumination equipment (30) has a laser beam generation section (32) and a mirror unit (34). An image generation section (90) has a camera (92) and a camera controller (94). A laser beam illumination control section (38) sets a pulse period of a laser beam to the same period as an exposure period of the camera (92). With this configuration, a state change of a specimen can be set uniform over exposure durations. A pulse train of the laser beam may be generated based on a synchronization signal which is output from the camera controller.

## Description

### TECHNICAL FIELD

The present disclosure relates to a transmission electron microscope, and in particular to a transmission electron microscope having a function to illuminate a laser beam onto a specimen.

### BACKGROUND

A transmission electron microscope has equipment which illuminates an electron beam onto a specimen, and a camera which detects electrons emitted from the specimen. The specimen is observed through an image captured by the camera. The camera generally includes a scintillator panel and a two-dimensional detector. Electrons are converted to photons in the scintillator panel, and the photons are detected by the two-dimensional detector. As the two-dimensional detectors, a CCD detector, a C-MOS detector, and the like are known. There are also known two-dimensional detectors that directly detect electrons.

When it is desired to observe a change of the specimen due to heating or to observe a photoreaction caused in the specimen, a laser beam is illuminated onto the specimen (refer to JP 2017-162557 A). In the related art, when a pulse train of a laser beam is illuminated onto the specimen, a pulse period of the laser beam and an exposure period of the camera are set independently from each other.

In a transmission electron microscope, when a pulse train of a laser beam is illuminated onto the specimen, a periodic change (such as a periodic motion or a periodic form change) may occur in the specimen. If the camera is periodically operated regardless of such a periodic change, a different state change may occur in the specimen for each exposure duration. In this case, it becomes difficult to correctly evaluate a plurality of images generated by the camera.

An advantage of the present disclosure lies in realizing an equal state change of a specimen caused in each exposure duration when a pulse train of a laser beam is illuminated onto the specimen in a transmission electron microscope.

### SUMMARY

According to one aspect of the present disclosure, there is provided a transmission electron microscope comprising: an electron beam illumination section that illuminates an electron beam onto a specimen; a laser beam illumination section that illuminates a laser beam formed from a pulse train onto the specimen; an image generation section that has a camera which detects electrons transmitting through the specimen, and that generates a camera image sequence during a simultaneous illumination process of the electron beam and the laser beam; and an illumination control section that controls an operation of the laser beam illumination section, and sets a pulse period of the laser beam to the same period as an exposure period of the camera.

### BRIEF DESCRIPTION OF DRAWINGS

Embodiment(s) of the present disclosure will be described based on the following figures, wherein:
FIG. 1 is a diagram showing a transmission electron microscope according to an embodiment of the present disclosure;
FIG. 2 is a diagram showing an upper part of an objective lens;
FIG. 3 is a diagram showing an example structure of a laser beam generation section;
FIG. 4 is a diagram showing a first example operation;
FIG. 5 is a diagram showing a second example operation; and
FIG. 6 is a diagram showing a third example operation.

### DESCRIPTION OF EMBODIMENTS

An embodiment of the present disclosure will now be described with reference to the drawings.

### (1) Overview of Embodiment

A transmission electron microscope according to an embodiment of the present disclosure includes an electron beam illumination section (a first illuminator), a laser beam illumination section (a second illuminator), an image generation section (a generator), and an illumination control section (a controller). The electron beam illumination section illuminates an electron beam onto a specimen. The laser beam illumination section illuminates a laser beam formed from a pulse train onto the specimen. The image generation section has a camera which detects electrons transmitting through the specimen, and generates a camera image sequence during a simultaneous illumination process of the electron beam and the laser beam. The illumination control section controls an operation of the laser beam illumination section, and sets a pulse period of the laser beam to the same period as an exposure period of the camera.

According to the structure described above, because the pulse period of the laser beam and the exposure period of the camera are matched, the state change of the specimen in each exposure duration becomes constant or uniform. Therefore, it becomes possible to correctly evaluate the plurality of camera images generated by the image generation section. For example, it becomes possible to correctly compare two camera images generated at different times.

An exposure duration is a duration from start of exposure until completion of the exposure. More specifically, the exposure duration is a duration in which photons (or electrons) continue to be detected in generation of each image frame. Each individual exposure duration is set according to the exposure period. The pulse period is a repetition period of a plurality of pulses. So long as the pulse period and the exposure period are synchronized, a reference timing of each pulse and a reference timing of each exposure duration may be deviated from each other. In an embodiment of the present disclosure, a camera is used which can output a detection signal while performing detection of the photons (or electrons).

In an embodiment of the present disclosure, the illumination control section determines a timing of generation of each pulse forming the pulse train based on a synchronization signal which indicates a reference time of each exposure duration in the camera. According to this structure, the pulse period can be reliably matched with the exposure period. The reference time described above is, for example, time of start of the exposure duration. Alternatively, the exposure period and the pulse period may be matched through a manual setting of the exposure period (or exposure time) and/or a manual setting of the pulse period.

In the transmission electron microscope according to an embodiment of the present disclosure, the image generation section includes a camera control section (a camera controller) which controls an operation of the camera so that a plurality of pulse illumination durations are excluded from a plurality of exposure durations in the camera. The above-described structure is desirably employed when problems such as signal saturation, noise generation, and the like are caused due to incidence of the laser beam on the camera.

The transmission electron microscope according to an embodiment of the present disclosure further includes a lens barrel which houses the electron beam illumination section. The laser beam illumination section includes a laser beam generation section (a laser beam generator) provided outside the lens barrel, and a mirror provided inside the lens barrel, and which reflects a laser beam from the laser beam generation section. A laser beam reflected by the mirror propagates along an optical axis, and is illuminated onto the specimen.

According to the structure described above, the laser beam illumination section can be placed even when there is no space for placing the laser beam generation section within the lens barrel. In addition, it becomes possible to avoid a situation in which the laser beam illumination section becomes a release source of contamination substances. Because a path of the laser beam reflected by the mirror becomes close to a path of the electron beam, the laser beam can be reliably illuminated with respect to an observation site.

The transmission electron microscope according to an embodiment of the present disclosure further includes an objective lens having an electron beam inlet, an electron beam outlet, and a specimen space which houses the specimen. The mirror is fixed on the objective lens. A laser beam reflected by the mirror propagates into the objective lens via the electron beam inlet.

According to the structure described above, a distance between a mirror unit and the specimen can be reduced. In addition, a positioning error of the mirror unit can be reduced, or adjustment of the mirror unit can be facilitated.

### (2) Details of Embodiment

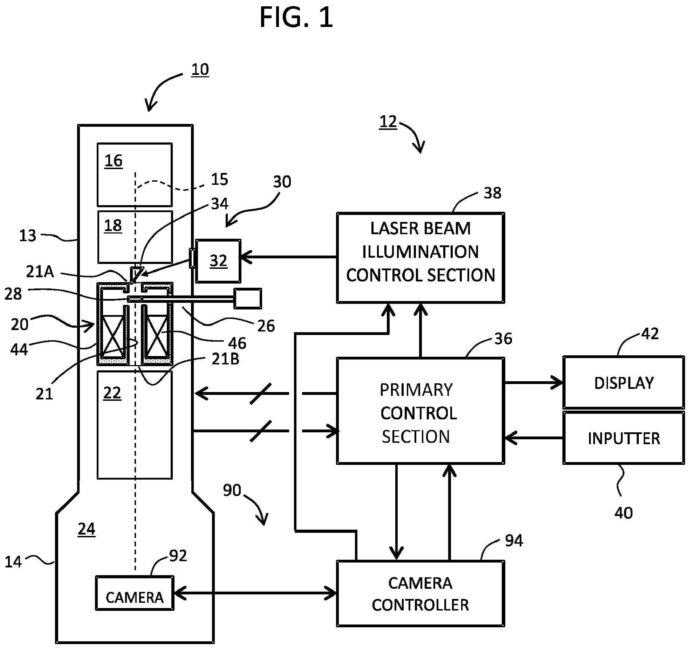

FIG. 1 shows an electron microscope according to a first embodiment of the present disclosure. The illustrated electron microscope is a scanning transmission electron microscope (STEM). The STEM has a convergence illumination mode and a parallel illumination mode. In the convergence illumination mode, an electron beam which converges on the specimen is scanned, and electrons transmitting through the specimen are detected. In the parallel illumination mode, an electron beam which is spread is illuminated onto the specimen, and electrons transmitting through the specimen are detected. In an embodiment of the present disclosure, in the parallel illumination mode, a camera image is generated through the detection of the electrons transmitting through the specimen. Alternatively, the camera image may be generated in the convergence illumination mode, through detection of electrons diffracted or scattered off the specimen.

The STEM has a measurement section 10 and an information processing section 12. The measurement section 10 has a lens barrel 13 and a lens barrel base 14. Vacuum equipment is provided for making insides of these sections vacuum, but illustration thereof is omitted in the figures. The information processing section 12 includes a primary control section 36, a laser beam illumination control section 38, and a camera controller 94.

A number of units are placed in the lens barrel 13 along an optical axis 15. Specifically, in the lens barrel 13, an electron gun 16, a condenser lens 18, an objective lens 20, an imaging lens 22 (a projection lens), and the like are provided. The optical axis 15 is a center axis in the illumination of the electron beam. In FIG. 1, the constituting elements in the lens barrel 13 are schematically illustrated.

An electron beam is generated by the electron gun 16. The generated electron beam enters the objective lens 20 via the condenser lens 18. The condenser lens 18 is formed from a plurality of lens elements, and applies an optical effect corresponding to a selected mode on the electron beam.

A specimen 28 is placed in the objective lens 20. The specimen 28 has, for example, a thin film (thin piece) form. Alternatively, powders or the like may be employed as the specimen 28. The specimen 28 is held by a specimen holder 26. A position and an orientation of the specimen 28 are adjusted by a mechanism (not shown).

The objective lens 20 has a yoke 44 and a coil 46. A polepiece is incorporated in the yoke 44. In the illustrated example structure, a specimen space exists at an upper part in the objective lens 20, and the specimen 28 is placed in the specimen space. In the objective lens 20, a position of the polepiece is offset on one side (upper side), and, on the other hand, a position of the coil 46 is offset on the other side (lower side). Alternatively, the specimen space may be set at an intermediate position in the up-and-down direction in the objective lens 20. The objective lens 20 has a passageway 21 formed by the optical axis 15. An upper end of the passageway 21 is an electron beam inlet 21A, and a lower end of the passageway 21 is an electron beam outlet 21B. Alternatively, an aberration corrector or the like may be provided between the condenser lens 18 and the objective lens 20. The structures from the electron gun 16 to the objective lens 20, provided in the lens barrel 13, correspond to an electron beam illumination section.

The imaging lens 22 is formed from a plurality of lens elements. An inside of the lens barrel base 14 is an observation chamber 24, and a plurality of detectors are placed in the observation chamber 24. In FIG. 1, illustration of detectors other than a camera 92 is omitted.

The camera 92 according to an embodiment of the present disclosure has a scintillator panel and a two-dimensional detector. The scintillator panel converts electrons into photons. The photons thus generated are detected by the two-dimensional detector. The two-dimensional detector is formed from a C-MOS detector, a CCD detector, or the like. Alternatively, as the camera 92, there may be employed a camera which has a two-dimensional detector which directly detects the electrons.

In an embodiment of the present disclosure, the camera 92 generates frame data for each exposure duration. Specifically, in the camera 92, data output with line data as a unit is repeatedly executed. That is, in the camera 92, the detection of electrons and the data output are executed in parallel with each other.

A camera controller 94 controls an operation of the camera 92. Specifically, the camera controller 94 determines parameters such as an exposure period. A plurality of exposure durations are set on a time axis according to the exposure period. With the camera controller 94, the frame data are sequentially read out from the camera 92.

The camera 92 and the camera controller 94 form an image generation section 90, mentioned above. With the image generation section 90, a plurality of sets of frame data corresponding to the plurality of exposure durations are generated, and a plurality of camera images are generated based on the plurality of sets of frame data. A camera image sequence is formed by the plurality of camera images. The camera image sequence is sent to the primary control section 36.

In an embodiment of the present disclosure, the camera controller 94 has a function to generate a synchronization signal. The synchronization signal has a synchronization pulse indicating a reference time (for example, an exposure start timing) in each exposure duration. That is, the synchronization signal has a plurality of synchronization pulses corresponding to the plurality of exposure durations. The synchronization signal is sent to the laser beam illumination control unit 38 as necessary.

The STEM according to an embodiment of the present disclosure comprises laser beam illumination equipment (a laser beam illumination section) 30. The laser beam illumination equipment 30 illuminates a laser beam formed from pulse trains onto the specimen. When it is desired to observe the specimen while heating the specimen, or to observe a photoreaction in the specimen, the laser beam is illuminated onto the specimen. Alternatively, in the laser beam illumination equipment 30, a laser beam formed from continuous waves may be generated.

The laser beam illumination equipment 30 has a laser beam generation section 32, and a mirror unit 34. In the laser beam generation section 32, a laser beam formed from a pulse train is generated, the generated laser beam is reflected by a mirror surface provided on the mirror unit 34, and the reflected laser beam is illuminated onto the specimen 28.

The laser beam generation section 32 is provided outside the lens barrel 13, and the mirror unit 34 is provided inside the lens barrel 13. With such a configuration, the laser beam generation section 32 is prevented from becoming a release source of contamination substances. On the mirror unit 34, a micro-through hole is formed along the optical axis, and electron beams pass through the through hole.

The primary control section 36 controls operations of various constituting elements of the STEM. Under control of the primary control section 36, the laser beam illumination control section 38 controls an operation of the laser beam generation section 32 in the laser beam illumination equipment 30. With the control of the laser beam illumination control section 38, the laser beam generation section 32 generates a pulse train having a set pulse period, a set pulse width, and a set pulse height.

The information processing section 12 has a processor which executes a program. As the processor, for example, a CPU may be exemplified. The actual substances of the primary control unit 36 and the camera controller 94 are programs. An inputter 40 and a display 42 are connected to the primary control section 36. The inputter 40 is formed from a keyboard or the like, and the display 42 is formed from an LCD or the like. An electron beam illumination condition, a laser beam illumination condition, and an imaging condition are set by a user using the inputter 40. The laser beam illumination condition includes the pulse period, the pulse width, and the pulse height. The imaging condition includes the exposure period (or the exposure duration).

The primary control section 36 has an image processing function. The primary control section 36 applies necessary image processing on the camera image sequence which is input. The image processing includes accumulation (a moving average process), FFT (fast Fourier Transform) calculation, and the like. With the FFT calculation on the camera image sequence, an FFT image sequence is obtained. For example, in an adjustment phase of the STEM, the camera image sequence and the FFT image sequence are displayed in parallel with each other while the pulse train is illuminated onto the specimen.

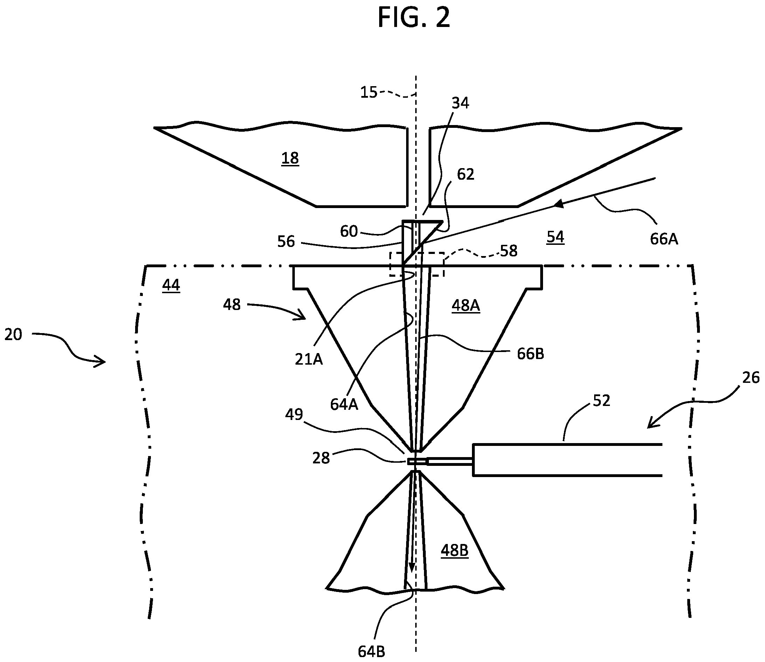

FIG. 2 shows an upper part of the objective lens 20 as an enlarged cross-sectional diagram. The objective lens 20 has the polepiece 48 incorporated in the yoke 44. The polepiece 48 has an upper part 48A and a lower part 48B which oppose each other with a gap therebetween. The gap corresponds to a specimen housing space 49. A passageway 64A is formed in the upper part 48A along the optical axis 15, and a passageway 64B is formed in the lower part 48B along the optical axis 15. An electron beam to be illuminated onto the specimen passes through the passageway 64A. An electron beam transmitting through the specimen (including diffracted or scattered electrons) passes through the passageway 64B.

The specimen holder 26 has a rod 52, and the specimen 28 is held at a tip of the rod 52. The position and the orientation of the specimen may be changed through the rod 52.

An opening 54 exists between the objective lens 20 and members provided thereabove (more specifically, the condenser lens 18), and the mirror unit 34 is provided in the opening 54. When the aberration corrector is provided above the objective lens 20, the mirror unit 34 is provided between the objective lens 20 and the aberration corrector.

The mirror unit 34 is formed from a mirror block 56 and a mirror base 58. These elements are formed from, for example, a metal such as aluminum. The mirror block 56 is fixed on the mirror base 58. The mirror base 58 is detachably connected to the upper part 48A of the polepiece 48. In this manner, the mirror unit 34 is attached at the electron beam inlet or at a proximity thereof in the objective lens 20.

The mirror block 56 has a through hole 60. The through hole 60 is formed along the optical axis 15, and the electron beam passes therethrough. The mirror block 56 has a mirror surface 62 serving as an inclined surface. At the mirror surface 62, a laser beam 66A from the generation section is reflected. The reflected laser beam 66B passes through the passageway 64A, and is illuminated onto the specimen 28.

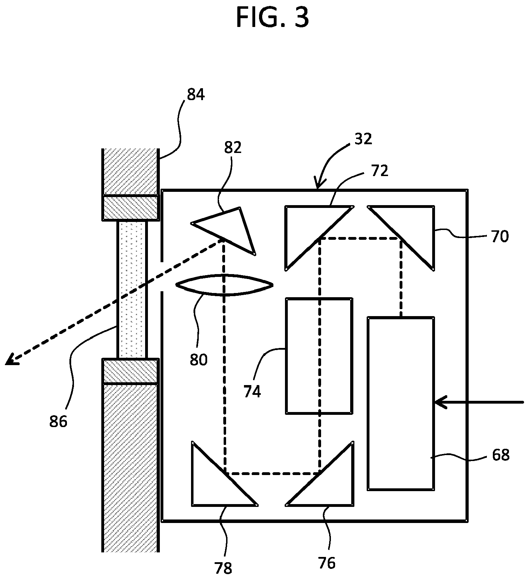

FIG. 3 shows an example structure of the laser beam generation section 32. The laser beam generation section 32 of a box shape is attached with respect to a housing 84 of the lens barrel. The housing 84 is formed from, for example, stainless steel. An inside of the housing 84 is a vacuum space, and an outside of the housing 84 is an atmospheric space. On the housing 84, a window 86 having optical transparency is provided.

The laser beam generation section 32 has a laser beam source 68, mirrors 70 and 72, a beam expander 74, mirrors 76 and 78, an optical lens 80, a movable mirror 82, and the like. The laser beam is generated at the laser beam source 68. More specifically, the laser beam source 68 generates a pulse train as the laser beam. The beam expander 74 realizes an effect to expand a cross-sectional size of the laser beam. The optical lens 80 realizes an optical effect on the laser beam so that a focal point of the laser beam is formed at a predetermined position in the objective lens or on the specimen surface. The movable mirror 82 is a mirror for finely adjusting a direction of illumination of the laser beam.

A mechanism for scanning the laser beam may be provided in the laser beam generation section 32, or a mechanism which can vary a size of an illumination region of the laser beam on the specimen may be provided in the laser beam generation section 32. An operation of the laser beam source 68 is controlled by the laser beam illumination control section 38 shown in FIG. 1.

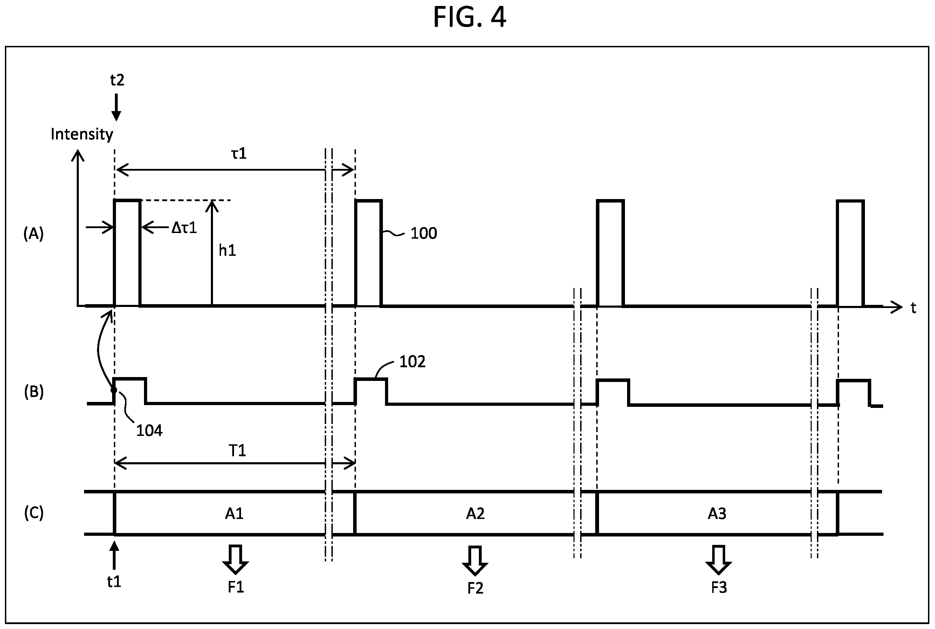

FIG. 4 shows a first example operation. FIG. 4 shows a relationship between illumination control and camera operation control; more specifically, a relationship between an illumination sequence and an exposure sequence. The electron beam and the pulse train of the laser beam are simultaneously illuminated onto the specimen.

Section (A) shows the illumination sequence; that is, the pulse train of the laser beam. Section (B) shows the synchronization signal, and section (C) shows the exposure sequence. In the first example operation, the illumination sequence and the exposure sequence are synchronized with the synchronization signal as a mediator. Alternatively, these sequences may be synchronized without the use of the synchronization signal.

The pulse train is formed from a plurality of pulses 100. A pulse period τ1 and a pulse width Δτ1 are set, for example, by the user. A pulse height h1 is set, for example, also by the user. The synchronization signal has a plurality of start pulses 102. The exposure sequence is a combination of a plurality of exposure durations A1, A2, and A3 on the time axis. A time length of each of the exposure durations A1, A2, and A3 is T1. In other words, the exposure period is T1. The exposure duration is a duration from the start of exposure to the completion of exposure; that is, a duration for obtaining one set of frame data, and corresponds to a shutter open duration.

In an embodiment of the present disclosure, the detection of electrons and the reading-out in units of line data are performed in the camera in parallel with each other, and each of the exposure durations A1, A2, and A3 does not have a non-detection duration. Alternatively, a plurality of exposure durations and a plurality of read-out durations may be determined within the exposure sequence. A plurality of sets of frame data F1, F2, and F3 corresponding respectively to the plurality of exposure durations A1, A2, and A3 are generated, and the camera image sequence is generated based on the frame data F1, F2, and F3.

In the first example operation, a start timing t1 of each exposure duration in the exposure sequence and a start timing t2 of each duration in the illumination sequence match each other. More specifically, each pulse 100 is generated with a rise 104 of each start pulse 102 as a trigger. So long as the illumination sequence and the exposure sequence are synchronized; that is, so long as the pulse train and the plurality of exposure durations are synchronized, the start timing t1 and the start timing t2 may be deviated from each other.

With the illumination of the pulse train onto the specimen, a periodic state change may occur in the specimen. For example, the specimen may periodically move, or a form of the specimen may periodically change. According to the first example operation, the state change of the specimen which occurs in each exposure duration can be matched. With such a configuration, the plurality of camera images can be appropriately evaluated.

When, for example, variation of an exposure duration is permitted, a minimum value of the exposure duration may be set as the actual exposure duration T1. In this case, a value identical to the minimum value is set for τ1. The pulse width may be determined based on the minimum value of the exposure duration. For example, a value of 1/100 of the minimum value may be set as the pulse width. Then, an optimum pulse height may be specified through an experiment. Needless to say, appropriate values are set for the parameters according to the specimen, the objective of observation, and the like.

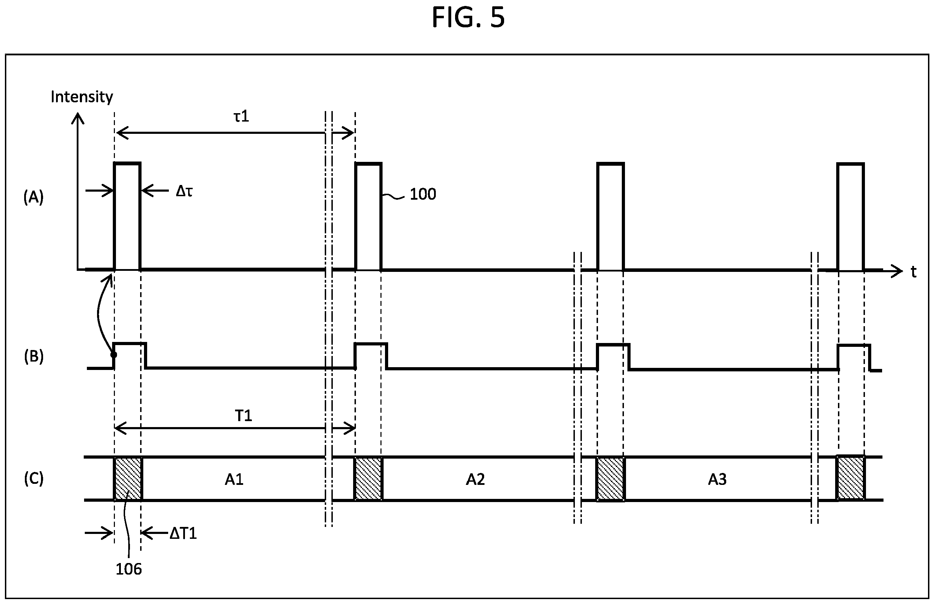

FIG. 5 shows a second example operation. In FIG. 5, elements similar to the elements shown in FIG. 4 are assigned the same reference numerals. Unlike the first example operation, in the second example operation, a non-detection duration (blank duration) 106 is determined within each of the exposure durations A1, A2, and A3. Each non-detection duration 106 matches or contains each pulse illumination duration. A time width ΔT1 of each non-detection duration 106 is greater than or equal to the pulse width Δτ1. According to the second example operation, in addition to the advantages obtained by the first example operation, an advantage can be obtained in that, even when the laser beam reaches the camera, problems possibly caused by the laser beam are not caused.

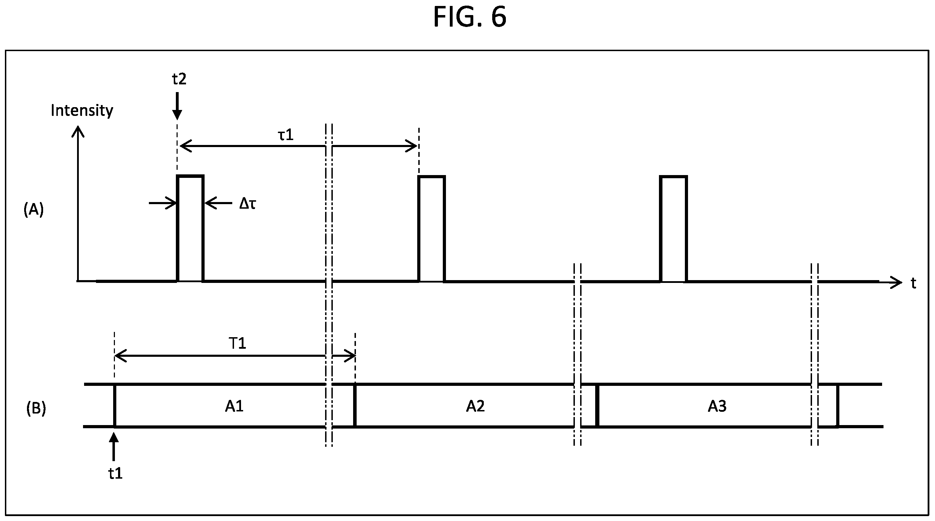

FIG. 6 shows a third example operation. Section (A) shows the pulse train, and section (B) shows the exposure sequence. In the third example operation, the synchronization signal is not used. A deviation is caused between the start timing t1 and the start timing t2. However, the pulse period τ1 and the exposure period T1 match each other. Therefore, in the third example operation also, advantages similar to the advantages obtained in the first example operation can be obtained. That is, a plurality of specimen state changes caused in a plurality of exposure durations can be set equal to each other.

## Claims

1. A transmission electron microscope comprising:
an electron beam illumination section (16, 18, 20) that illuminates an electron beam onto a specimen;
a laser beam illumination section (30) that illuminates laser beam formed from a pulse train onto the specimen;
an image generation section (90) that has a camera which detects electrons transmitting through the specimen, and that generates a camera image sequence during a simultaneous illumination process of the electron beam and the laser beam; and
an illumination control section (38) that controls an operation of the laser beam illumination section (30), and that sets a pulse period of the laser beam to the same period as an exposure period of the camera.

2. The transmission microscope according to claim 1, wherein
the illumination control section (38) determines a timing of generation of each pulse forming the pulse train based on a synchronization signal which indicates a reference time of each exposure duration in the camera (92).

3. The transmission electron microscope according to any preceding claim, wherein
the image generation section (90) includes a camera control section (94) which controls an operation of the camera so that a plurality of pulse illumination durations are excluded from a plurality of exposure durations in the camera.

4. The transmission electron microscope according to any preceding claim, further comprising:
a lens barrel (13) which houses the electron beam illumination section (16, 18, 20), wherein
the laser beam illumination section (30) comprises:
a laser beam generation section (32) provided outside the lens barrel; and
a mirror (56) provided inside the lens barrel (13), and which reflects a laser beam from the laser beam generation section (32), and
a laser beam reflected by the mirror (56) propagates along an optical axis, and is illuminated onto the specimen.

5. The transmission electron microscope according to claim 4, further comprising:
an objective lens (20) having an electron beam inlet, an electron beam outlet, and a specimen space which houses the specimen, wherein
the mirror (56) is fixed on the objective lens (20), and
a laser beam reflected by the mirror (56) propagates into the objective lens (20) via the electron beam inlet.
